# EUROPÄISCHE PATENTSCHRIFT

(11) **EP 0 381 111 B1**
(45) Veröffentlichungstag und Bekanntmachung des Hinweises auf die Patenterteilung: **31.05.1995**
(21) Anmeldenummer: 90101718.6
(22) Anmeldetag: 29.01.1990
(51) Int. Cl.: H01L 23/29

(54) **Elektroaktive Passivierschicht**
Electroactive-passivation film
Couche de passivation électroactive

(30) Priorität: 01.02.1989 DE 3902970
(43) Veröffentlichungstag der Anmeldung: 08.08.1990
(73) Patentinhaber: SIEMENS AKTIENGESELLSCHAFT, 80333 München (DE)
(72) Erfinder: Birkle, Siegfried, Dr., D-8552 Höchstadt/Aisch (DE); Kammermaier, Johann, Dr., D-8025 Unterhaching (DE); Schmidt, Gerhard, Dr., D-8550 Forchheim (DE); Winnacker, Albrecht, Prof. Dr., D-8520 Erlangen (DE)

(56) Entgegenhaltungen:
- DE-A- 3 316 693
- US-A- 4 060 660
- US-A- 4 254 426
- IDR- Industrie Diamanten Rundschau Bd. 18, Nr. 4, 1984, Seiten 249-253; B. DISCHLER et al.: "Eigenschaften und Anwendungen harter amorpher Kohlenstoffschichten"
- PATENT ABSTRACTS OF JAPAN vol. 10, no. 215 (P-481) 26 Juli 1986 & JP-A-61 054036

## Beschreibung

Die Erfindung betrifft eine elektroaktive Passivierschicht für Halbleiterbauelemente sowie ein Verfahren zu deren Herstellung.

Diskrete und integrierte Halbleiterbauelemente, insbesondere solche in MOS-Technologien, sind empfindlich gegen Störungen durch Oberflächenladungen und benötigen deshalb, vor allem an den Stellen, an denen pn-Übergänge an die Oberfläche treten, halbleitende elektroaktive Passivier- und Schutzschichten. An derartige Passivierschichten werden folgende Anforderungen gestellt:
- Es muß eine günstige elektrische Ankopplung der Schicht an n- und p-leitende aktive Substrate ohne Sperrschichteffekte möglich sein, d.h. es müssen kleine Barrieren und damit hohe Sperrströme (ohmsche Kontakte) gegeben sein. Diese Forderung bedeutet eine hohe Defektdichte in der Bandlücke und eine ausreichende intrinsische Leitfähigkeit durch einen hopping-Mechanismus oder einen optischen Bandabstand (mobility gap) zwischen 1,1 und 1,4 eV, damit thermisch eine ausreichende Zahl von Ladungsträgern generiert werden kann.
- Die elektrische Leitfähigkeit (bei Raumtemperatur) muß unterhalb 10⁻⁸Ω⁻¹.cm⁻¹ liegen, damit parasitäre Oberflächenströme kleiner bleiben als Sperrströme zwischen p- und n-leitenden Bereichen des zu schützenden Halbleiters.
- Es muß ein ausreichender Abschirmeffekt für die n- und p-leitenden Teile des zu schützenden Halbleiters gegeben sein. Dazu müssen die Schutz- und Passivierschichten - neben einer hohen Dichte an umladbaren Zuständen (bis zu einigen 10¹⁹ cm⁻³.ev⁻¹) - vor allem eine geringe Driftbeweglichkeit der Ladungen aufweisen.
- Die Passivierschichten müssen frei von pinholes sein, einen niedrigen Permeationskoeffizienten für Wasserstoff und Wasser aufweisen, sowie einen mechanischen und einen Feuchteschutz bieten.
- Bei einer - herstellungsbedingten - Erwärmung der Halbleiterbauelemente auf 290°C dürfen die Passivierschichten keinen Wasserstoff abgeben.

Als elektroaktive Passivierschichten für Halbleiterbauelemente dienen derzeit Schichten aus amorphem Silicium (a-Si). Man kann diese Schichten auf die Halbleiterbauelemente aufwachsen lassen, das Silicium kann aber auch aufgedampft werden, wobei die aufgedampfte Schicht dann getempert wird (siehe dazu DE-OS 27 30 367). Zur Einstellung des spezifischen elektrischen Widerstandes können die Passivierschichten Dotierstoffe enthalten, wie Bor, Phosphor und Aluminium.

Elektroaktive Passivierschichten aus a-Si enthalten zwar in ausreichender Menge Defektzustände in der Bandlücke, der geforderte Widerstandswert um 10⁸Ω.cm kann über die Abscheide- und Sinterbedingungen eingestellt werden, und der Einfluß einer Dotierung wirkt sich wegen der hohen Zustandsdichte nur schwach aus. Ein gravierender Nachteil dieser Schichten besteht aber darin, daß sie sich an p-leitende Substrate wesentlich schlechter ankoppeln lassen als an n-leitende Substrate. Dies kann dann zu Oberflächendurchbrüchen an hochsperrenden pn-Übergängen führen. Auch läßt sich bei a-Si-Schichten der optische Bandabstand kaum variieren und somit nicht an beliebige aktive Substrate anpassen. Besonders nachteilig ist bei diesen Schichten ferner die mangelnde Stabilität gegen Feuchte, Ionendiffusion und mechanische Einwirkungen.

Aufgabe der Erfindung ist es, eine halbleitende elektroaktive Passivierschicht für Halbleiterbauelemente anzugeben, die - neben einer hohen Defektdichte in der Bandlücke, einer ausreichend niedrigen elektrischen Leitfähigkeit und dem erforderlichen optischen Bandabstand - eine gute Stabilität gegen Feuchte, Ionendiffusion und mechanische Einwirkungen aufweist und sich sowohl an p-leitende als auch an n-leitende Substrate gut ankoppeln läßt.

Dies wird erfindungsgemäß dadurch erreicht, daß die Passivierschicht aus einer dünnen Schicht aus amorphem, wasserstoffhaltigem Kohlenstoff (a-C:H) besteht.

Amorpher, wasserstoffhaltiger Kohlenstoff, kurz a-C:H, ist ein Kohlenstoffmaterial, bei dem ein amorphes Kohlenstoffnetzwerk vorliegt; aufgrund seiner mechanischen Härte wird dieses Kohlenstoffmaterial auch als diamantartiger Kohlenstoff bezeichnet (siehe beispielsweise: "IDR - Industrie Diamanten Rundschau", Bd. 18 (1984), Nr. 4, Seiten 249 ff.). Diese amorphe Modifikation von Kohlenstoff erhält ihre besonderen Eigenschaften, wie optische Transparenz, Mikrohärte, chemische Resistenz und elektrische Isolation, durch das Nebeneinander von tetraedrischer (sp³-) und trigonaler (sp²-) Hybridisierung sowie durch den Einbau von Wasserstoff (etwa 10 bis 40 Atom-%).

Die erfindungsgemäße Passivierschicht in Form von a-C:H-Dünnschichten, die vorzugsweise eine Dicke etwa zwischen 0,05 und 3 »m aufweisen, erfüllt alle Anforderungen, die sich bei der elektroaktiven Passivierung von oberflächenladungsempfindlichen Halbleiterbauelementen ergeben. Im Gegensatz zu a-Si läßt sich a-C:H - über die Bedingungen bei seiner Herstellung - mit verschiedenem optischen Bandabstand, variabler Defektdichte und variablem elektrischen Widerstand ohne die Notwendigkeit von Dotierprozessen herstellen. So ist es insbesondere möglich, mit a-C:H-Schichten folgende Werte gleichzeitig und optimal zu erfüllen: Defektdichte von ca. 10¹⁹ cm⁻³.eV⁻¹; elektrische Leitfähigkeit < 10⁻⁸Ω⁻¹.cm⁻¹; optischer Bandabstand von ca. 1,1 eV.

Die Herstellung der erfindungsgemäßen elektroaktiven Passivierschicht erfolgt in der Weise, daß auf ein Substrat durch eine Hochfrequenz-Niederdruck-Plasmaabscheidung gasförmiger Kohlenwasserstoffe eine dünne Schicht aus amorphem, wasserstoffhaltigem Kohlenstoff aufgebracht wird. Die Plasmaabscheidung erfolgt dabei vorzugsweise mittels Radiofrequenz (RF), d.h. im Bereich zwischen 0,1 und 100 MHz, sie kann aber auch mittels Mikrowellen (MW) erfolgen, d.h. im Bereich zwischen 0,1 und 1000 GHz.

Als gasförmige Kohlenwasserstoffe dienen bei der Herstellung der erfindungsgemäßen Passivierschicht vorteilhaft Alkane, d.h. gesättigte aliphatische Kohlenwasserstoffe, wie Methan, Ethan und Propan; dabei wird Methan bevorzugt. Daneben können aber auch Alkene, d.h. ungesättigte aliphatische Kohlenwasserstoffe, wie Ethen und Propen, eingesetzt werden, sowie Acetylen, Cycloalkane, d.h. gesättigte cyclische Kohlenwasserstoffe, wie Cyclohexan, und - im dampfförmigen Zustand - aromatische Kohlenwasserstoffe in Form von Benzol und Benzolderivaten. Die Kohlenwasserstoffe der vorstehend genannten Art können einzeln oder im Gemisch zum Einsatz gelangen. Den Kohlenwasserstoffen können ferner Wasserstoff und/oder Edelgase, wie Helium und Argon, zugegeben werden.

In Hochfrequenzentladungen, insbesondere mit RF-Anregung, bildet sich bei unterschiedlich großen Innenelektroden der Entladungseinrichtung (Flächenverhältnis ≦ 0,5, vorzugsweise zwischen 0,25 und 0,05) - aufgrund von Raumladungen - eine im Takt der Hochfrequenz (HF) pulsierende Gleichstrom-Spannungskomponente (Vorspannung bzw. "self bias potential") bis zu etwa 1 kV aus. Diese DC-Spannungskomponente überlagert sich der HF-Wechselspannung und macht die kleinere Elektrode zur Kathode. Dadurch werden die geladenen CₓH_{y}-Teilchen, die durch Ionisierung und Fragmentierung des Reaktionsgases entstehen, zur Kathode hin beschleunigt und auf dem vor der Kathode angeordneten Substrat mit hoher kinetischer Energie - unter Bildung von a-C:H - abgeschieden. Ein "self bias"-Effekt der vorstehend genannten Art ist, wenngleich - wegen des Fehlens von Innenelektroden - in sehr viel geringerem Ausmaß, auch bei MW-induzierten Abscheideplasmen wirksam, weil zwischen Plasma und Substratfläche in jedem Fall eine Potentialdifferenz besteht.

Über die Bedingungen bei der Plasmaabscheidung kann a-C:H mit unterschiedlichen Eigenschaften hergestellt werden. Die variablen Bedingungen sind dabei die Frequenz der HF-Entladung, die in das Plasma eingespeiste Energiedichte, die Konfiguration und die Größe der Elektroden, der Gasdruck, d.h. der Partialdruck des Reaktionsgases, die Gasdurchflußrate bzw. der Massedurchfluß und die Substrattemperatur (≧ 250°C). Alle diese Parameter lassen sich unabhängig voneinander einstellen, und auf diese Weise können die Eigenschaften der a-C:H-Schichten gezielt gesteuert werden.

Anhand eines Ausführungsbeispiels wird die Erfindung noch näher erläutert.

In eine Apparatur zur Plasmaabscheidung von a-C:H mittels RF-Anregung in Form eines zylindrischen Glasgefäßes wird seitlich Methan CH₄ (als Reaktionsgas) bei einem Druck von 100 Pa eingeleitet. Das Reaktionsgas gelangt über einen engen Ringspalt in das sich zwischen zwei ungleichen, planaren Elektroden (Flächenverhältnis 1:2) ausbildende Plasma mit einem Volumen von ca. 45 cm³. Die beiden Elektroden sind mit einem RF-Generator verbunden (γ= 13,56 MHz). Aufgrund der ungleichen Elektroden entsteht zwischen diesen eine - sich der RF-Spannung überlagernde - self bias-DC-Spannung, wobei die kleinere Elektrode, welche die zu beschichtenden Substrate trägt, zur Kathode wird.

Bei einer Hochfrequenz-Leistungsdichte von ca. 14 W.cm⁻², bezogen auf die Kathodenfläche, entsteht zwischen den beiden Elektroden eine self bias-DC-Spannung von ca. 800 V. Unter diesen Bedingungen erhält man bei einem CH₄-Massedurchfluß von 5.10⁴ Pa.cm³.s⁻¹ nach 2 1/2 min (Abscheiderate: ca. 7 nm.s⁻¹) eine ca. 1 »m dicke a-C:H-Schicht mit einem spezifischen elektrischen Widerstand > 10⁸Ω.cm bei Raumtemperatur und einem optischen Bandabstand von ca. 1,1 eV; die Defektdichte im Fermi-Niveau beträgt bei dieser a-C:H-Schicht ca. 10¹⁹ cm⁻³.eV⁻¹.

## Patentansprüche

1. Elektroaktive Passivierschicht für Halbleiterbauelemente, bestehend aus einer dünnen Schicht aus amorphem wasserstoffhaltigem Kohlenstoff (a-C:H) mit einer Defektdichte von ca. 10¹⁹ cm⁻³.eV⁻¹, einem spezifischen elektrischen Widerstand > 10⁸ Ω.cm und einem optischen Bandabstand von ca. 1,1 eV.

2. Passivierschicht nach Anspruch 1, **dadurch gekennzeichnet**, daß sie eine Dicke etwa zwischen 0,05 »m und 3 »m aufweist.

3. Verfahren zur Herstellung einer elektroaktiven Passivierschicht nach Anspruch 1 oder 2, wobei auf ein Substrat durch eine Hochfrequenz-Niederdruck-Plasmaabscheidung gasförmiger Kohlenwasserstoffe eine dünne Schicht aus amorphem wasserstoffhaltigem Kohlenstoff aufgebracht wird und die Bedingungen bei der Plasmaabscheidung so eingestellt werden, daß die dünne Schicht aus amorphen wasserstoffhaltigem Kohlenstoff eine Defektdichte von ca. 10¹⁹ cm⁻³.eV⁻¹, einen spezifischen elektrischen Widerstand > 10⁸ Ω.cm und einen optischen Bandabstand von ca. 1,1 eV aufweist.

4. Verfahren nach Anspruch 3, **dadurch gekennzeichnet**, daß die Plasmaabscheidung bei einer Self-bias-Spannung bis zu etwa 1 kV erfolgt.

5. Verfahren nach Anspruch 3 oder 4, **dadurch gekennzeichnet**, daß die Plasmaabscheidung mittels Radiofrequenz erfolgt.

6. Verfahren nach einem der Ansprüche 3 bis 5, **dadurch gekennzeichnet**, daß als Kohlenwasserstoffe Alkane eingesetzt werden, insbesondere Methan.

7. Verfahren nach einem oder mehreren der Ansprüche 3 bis 6, **dadurch gekennzeichnet**, daß das Substrat während der Abscheidung auf einer Temperatur ≧ 250°C gehalten wird.

## Claims

1. An electro-active passivation layer for semiconductor components comprising a thin layer of amorphous, hydrogenous carbon (a-C:H) with a defect density of approximately 10¹⁹cm⁻³.eV⁻¹, a specific electrical resistance >10⁸Ω.cm and an optical mobility gap of approximately 1.1 eV.

2. A passivation layer according to Claim 1, characterised in that it possesses a thickness of approximately between 0.05 »m and 3 »m.

3. A process for the production of an electro-active passivation layer according to Claim 1 or 2 wherein a thin layer of amorphous, hydrogenous carbon is applied to a substrate by high-frequency low-pressure plasma precipitation of gaseous hydrocarbons and the conditions of the plasma precipitation are set such that the thin layer of amorphous, hydrogenous carbon possesses a defect density of approximately 10¹⁹cm⁻³.eV⁻¹, a specific electrical resistance >10⁸Ω.cm and an optical mobility gap of approximately 1.1 eV.

4. A process according to Claim 3, characterised in that the plasma precipitation takes place at a self-bias voltage of up to approximately 1 kV.

5. A process according to Claim 3 or 4, characterised in that the plasma precipitation takes place by means of radio frequency.

6. A process according to one of Claims 3 to 5, characterised in that alkanes, in particular methane, are used as hydrocarbons.

7. A process according to one or more of Claims 3 to 6, characterised in that the substrate is maintained at a temperature ≧ 250°C during the precipitation.

## Revendications

1. Couche de passivation électro-active pour des dispositifs semi-conducteurs, constituée par une couche mince en carbone hydrogéné amorphe (a-C:H) comportant une densité de lacunes d'environ 10¹⁹ cm⁻³.eV⁻¹, une résistance électrique spécifique > 10⁸Ω.cm et un intervalle optique entre deux bandes d'environ 1,1 eV.

2. Couche de passivation selon la revendication 1, caractérisée en ce qu'elle présente une épaisseur d'environ 0,05 »m à 3 »m.

3. Procédé pour la fabrication d'une couche de passivation électro-active selon la revendication 1 ou 2, dans lequel, sur un substrat, par déposition plasmatique à basse-pression et à haute-fréquence d'hydrocarbures gazeux, on applique une mince couche en carbone hydrogéné amorphe et on règle les conditions lors de la déposition plasmatique de telle sorte que la mince couche en carbone hydrogéné amorphe présente une densité de lacunes d'environ 10¹⁹ cm⁻³.eV⁻¹, une résistance électrique spécifique > 10⁸Ω.cm et un intervalle optique entre deux bandes d'environ 1,1 eV.

4. Procédé selon la revendication 3, caractérisé en ce que la déposition plasmatique a lieu avec une tension d'autopolarisation jusqu'à environ 1 kV.

5. Procédé selon la revendication 3 ou 4, caractérisé en ce que la déposition plasmatique a lieu au moyen de radiofréquences.

6. Procédé selon l'une quelconque des revendications 3 à 5, caractérisé en ce que, comme hydrocarbures, on met en oeuvre des alcanes, en particulier le méthane.

7. Procédé selon l'une ou plusieurs des revendications 3 à 6, caractérisé en ce qu'on maintient le substrat pendant la déposition à une température ≧ 250°C.
